(19) Europäisches Patentamt
European Patent Office
Office européen des brevets

(11) **EP 2 851 693 B1**

(12) **FASCICULE DE BREVET EUROPEEN**

(45) Date de publication et mention
de la délivrance du brevet:
**31.10.2018 Bulletin 2018/44**

(21) Numéro de dépôt: **14184958.8**

(22) Date de dépôt: **16.09.2014**

(51) Int Cl.:
*G01R 27/26* (2006.01)   *H01P 5/04* (2006.01)
*G01R 21/00* (2006.01)   *G01N 22/00* (2006.01)
*G01N 27/22* (2006.01)   *H01P 5/103* (2006.01)
*H01P 7/06* (2006.01)

(54) **Dispositif pour la mesure du facteur de qualite d'une cavite, notamment d'une cavite supraconductrice, perturbee par des decharges electroniques resonantes.**

Vorrichtung zum Messen des Qualitätsfaktors einer Kavität, insbesondere einer supraleitenden Kavität, die durch elektronische Resonanzentladungen gestört wird

Device for measuring the quality factor of a cavity, in particular a superconducting cavity, disrupted by resonating electronic discharges

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.09.2013 FR 1359059**

(43) Date de publication de la demande:
**25.03.2015 Bulletin 2015/13**

(73) Titulaire: **COMMISSARIAT À L'ÉNERGIE ATOMIQUE ET AUX ÉNERGIES ALTERNATIVES**
**75015 Paris (FR)**

(72) Inventeur: **Luong, Michel**
**92330 SCEAUX (FR)**

(74) Mandataire: **Cabinet Camus Lebkiri**
**25 rue de Maubeuge**
**75009 Paris (FR)**

(56) Documents cités:
**FR-A1- 2 718 247   US-A- 4 642 571**

• **Jens Knobloch: "Basic Concepts of Measurements Made on Superconducting RF Cavities", , 30 août 1991 (1991-08-30), XP055123352, Extrait de l'Internet: URL:http://www.lns.cornell.edu/public/SRF/ 1991/SRF910927-07/srf910927-07.pdf [extrait le 2014-06-13]**

## Description

## DOMAINE TECHNIQUE

Le domaine de l'invention est celui de la caractérisation des résonateurs (ou cavités résonantes) sous vide, présentant de très faibles pertes et qui sont susceptibles d'être perturbés par des décharges électroniques résonantes.

L'invention s'applique particulièrement à des cavités résonantes hautes fréquences construites en matériaux supraconducteurs.

La présente invention concerne plus particulièrement un dispositif pour mesurer le facteur de qualité $Q_0$, correspondant au facteur de qualité à vide d'une cavité résonante, défini par le quotient de l'énergie stockée par la puissance dissipée, multiplié par la pulsation $\omega_0$ (appelée également fréquence angulaire) à la résonance.

## ETAT DE LA TECHNIQUE

Dans une cavité résonante, la puissance peut être dissipée à la fois dans les matériaux enfermés dans le résonateur, généralement diélectriques, ainsi que sur les parois. Il est alors possible de mesurer respectivement la permittivité complexe des diélectriques et/ou la résistance de surface des conducteurs formant les parois de la cavité résonante.

Dans certaines situations, ces caractéristiques étant susceptibles de varier en fonction de l'énergie stockée, il est nécessaire de mesurer le facteur de qualité $Q_0$ à différentes amplitudes des champs électromagnétiques. Dans le cas des cavités résonantes supraconductrices, utilisées par exemple pour accélérer un faisceau de particules, la mesure de $Q_0$ en fonction du gradient accélérateur (champ électrique) jusqu'à la transition brutale du matériau supraconducteur vers l'état de conduction normale (appelée « quench ») représente une caractérisation indispensable.

Dans certaines situations, ces mesures du facteur de qualité $Q_0$ peuvent être rendues impraticables par l'apparition d'un phénomène de décharges électroniques résonantes, notamment lors de la phase de stockage de l'énergie dans la cavité résonante, également appelée phase de remplissage, pendant laquelle la cavité résonante emmagasine progressivement l'énergie.

Le phénomène de décharge électronique résonante (en anglais « multipactor ») dans les structures sous vide à haute fréquence est connu depuis 1936 et notamment décrit dans le document J.M.R. Vaughan, « Multipactor », IEEE transaction on electron devices, vol. 35, n°7, 1988.

La décharge électronique résonante prend sa source dans la capacité d'une surface métallique ou diélectrique à émettre un ou plusieurs électrons, dits électrons secondaires, lorsqu'elle est frappée par un électron incident dont l'énergie cinétique est comprise dans une gamme particulière variable selon le matériau, typiquement entre 0,1 et 1 keV. Ce phénomène est de nature aléatoire et est défini par un rendement statistique appelé coefficient d'émission secondaire. Ainsi, la décharge électronique résonante ne peut se produire que lorsque le coefficient d'émission secondaire est supérieur à 1. Par ailleurs, des conditions supplémentaires doivent également être réunies pour que la décharge électronique résonante se maintienne dans la cavité.

Pour comprendre le problème posé par le phénomène de décharge électronique résonante lors de la caractérisation du facteur de qualité $Q_0$ d'une cavité résonante haute fréquence, à faible perte, il est nécessaire de rappeler la méthode de mesure du facteur de qualité à vide et ses contraintes.

Le principe consiste à « remplir » la cavité résonante d'énergie grâce à un générateur de puissance. Lorsque l'état stationnaire est atteint, la puissance incidente est coupée et on laisse la cavité résonante se vider. On mesure alors le signal de sortie et le temps d'amortissement qui permet de calculer le facteur de qualité $Q_0$.

Pour réaliser une telle mesure, la cavité est connectée à deux ports : un port en entrée (dit port incident) et un port en sortie (dit port transmis). Généralement, ces ports sont constitués physiquement par une antenne coaxiale qui pénètre plus ou moins profondément dans la cavité. Chaque port est caractérisé par un coefficient de couplage $\beta_e$ défini par le ratio $Q_0/Q_e$, où $Q_e$ est le facteur de qualité externe associé au port.

Le facteur de qualité externe $Q_e$ est défini par le quotient de l'énergie stockée par la puissance dissipée à travers le port, multiplié par la pulsation $\omega_0$ (appelée également fréquence angulaire) à la résonance. Par conséquent, les ports incidents et transmis sont respectivement caractérisés par un coefficient de couplage $\beta_i$ et $\beta_t$, associé à un facteur de qualité $Q_i$ et $Q_t$.

Ainsi, le système dans son ensemble, formé par la cavité résonante connectée aux antennes, présente un facteur de qualité global $Q_L$ en charge où la puissance dissipée par le système est la somme des dissipations des matériaux de la cavité et des ports. Il en découle ainsi une relation suivante :

$$\frac{1}{Q_L} = \frac{1}{Q_0} + \frac{1}{Q_i} + \frac{1}{Q_t}$$

Le facteur de qualité en charge $Q_L$ est mesuré à travers la décroissance dans le temps de la puissance transmise $P_t$ qui suit la loi suivante :

$$P_t = P_{t0} e^{-t/\tau}$$

où $\tau$ est le temps d'amortissement de la cavité, qui est égal par réciprocité au temps de remplissage de la cavité.

En pratique, le couplage du port transmis est choisi très faible, c'est-à-dire que le facteur de qualité $Q_t$ est très grand devant $Q_0$ ce qui permet de le négliger pour la détermination du facteur de qualité à vide $Q_0$, de sorte que :

$$Q_0 \approx (1 + \beta_i)Q_L$$

Par ailleurs, il est connu qu'à la résonance de la cavité le coefficient de couplage du port incident $\beta_i$ s'écrit :

$$\beta_i = \frac{2}{\eta} - 1 \pm \sqrt{\left(\frac{2}{\eta} - 1\right)^2 - 1}$$

où $\eta$ est le ratio $P/P_i$ avec $P$ et $P_i$ représentant respectivement la puissance absorbée et la puissance incidente.

La puissance absorbée s'obtient par différence entre la puissance incidente et la puissance réfléchie, mesurée via un coupleur directionnel ; la puissance transmise pouvant être négligée en raison du choix du coefficient de couplage $\beta_t$ très faible.

En pratique, le coefficient de couplage incident $\beta_i$ est choisi proche de 1 (condition dite de couplage critique) pour minimiser la puissance réfléchie par la cavité et ainsi que pour maximiser la puissance absorbée par la cavité de manière à obtenir le maximum d'énergie stockée, i.e. par exemple le maximum du gradient accélérateur pour une cavité accélératrice, pour une puissance donnée fournie par le générateur. Or dans ces conditions, le temps de remplissage de la cavité peut devenir très long devant le temps d'amorçage de la décharge électronique résonante, ce qui favorise les conditions d'apparition de décharges électronique résonantes.

Bien que le champ électromagnétique dans la cavité augmente avec le temps au cours du remplissage, cette variation reste trop faible, préservant par conséquent les conditions de résonance permettant à la décharge de s'amorcer et/ou de se maintenir lors de la phase de remplissage.

Pour résoudre ce problème, il suffirait alors de choisir un coefficient de couplage incident $\beta_i$ très grand afin de raccourcir le temps de remplissage et ainsi empêcher l'établissement des conditions stables pour l'émission électronique secondaire.

Mais en réalisant ceci, l'erreur relative sur la mesure du facteur de qualité à vide, directement proportionnelle au coefficient de couplage incident $\beta_i$, devient très élevée et incompatible avec la précision de mesure souhaitée.

A défaut de possibilité de remplissage rapide de la cavité, différentes solutions ont été mises en place de manière à tenter de lutter contre le phénomène de décharge électronique résonante.

Une première solution consiste à réaliser des simulations numériques de manière à anticiper les conditions d'apparition des décharges électroniques résonantes et à modifier géométriquement la cavité de manière à supprimer les formes susceptibles de favoriser l'apparition des décharges électroniques résonantes.

Une deuxième solution consiste à modifier le coefficient d'émission secondaire par un traitement des surfaces internes de la cavité avec un dépôt de couche mince ou par un traitement chimique.

Une troisième solution consiste à appliquer un champ électrique ou magnétique statique lorsque cela est possible pour rompre les conditions de résonance.

Toutefois, ces solutions sont contraignantes et ne sont applicables que lors de la phase de conception des cavités et n'est par conséquent pas applicable sur les cavités déjà existantes.

Une fois que la cavité résonante est construite, il est connu de « roder » les surfaces internes de la cavité au cours de la décharge dans l'espoir de modifier le coefficient d'émission secondaire. En effet, le « rodage » permet de provoquer, par des impacts répétés des électrons, une désorption des surfaces qui peut modifier le coefficient d'émission secondaire.

Dans le cas des cavités supraconductrices où la très basse température favorise l'adsorption des molécules de gaz résiduels, le rodage prend souvent plusieurs heures pour passer une seule barrière et est parfois inopérant. Dans ce cas, il est encore possible de réaliser un cycle de réchauffement et de refroidissement de la cavité résonante qui dure au moins une journée.

Une autre solution, décrite dans la publication de Jens Knobloch: "Basic Concepts of Measurements Made on Superconducting RF Cavities", 30 août 1991. XP055123352, propose d'utiliser un moteur pour déplacer la cavité résonante par rapport à la ligne de transmission de manière à modifier le coefficient de couplage au niveau du port d'entrée entre la phase de remplissage et la phase de mesure.

Le document FR 27118247 A1 décrit un dispositif de protection d'un détecteur de type radar contre la réception de signaux haute énergie avec un temps de réponse court. La protection est notamment réalisée par un guide d'onde associé à une ligne coaxiale court-circuitée et comportant au moins une diode, de type PIN.

**EXPOSE DE L'INVENTION**

Dans ce contexte, la présente invention vise à résoudre les problèmes mentionnés précédemment en proposant un dispositif et plus généralement un système pour la caractérisation du facteur de qualité à vide d'une cavité résonante à très faible perte, notamment du type supraconductrice, permettant d'éviter l'apparition du phénomène de décharge électronique résonante (« multipactor ») au cours de la caractérisation, permettant ainsi de réaliser des mesures précises et rapides du facteur de qualité à vide d'une telle cavité.

A cette fin, l'invention propose un dispositif pour mesurer le facteur de qualité à vide d'une cavité résonante présentant un port d'entrée pour recevoir une puissance incidente et un port de sortie pour prélever et mesurer une partie de l'énergie stockée dans ladite cavité résonante, ledit dispositif comportant une ligne de transmission apte à être couplée au port d'entrée de ladite cavité résonante à caractériser, présentant un coefficient de couplage $\beta_i$ et apte à transmettre une puissance incidente; ledit dispositif étant **caractérisé en ce qu'**il comporte un moyen de commutation formé par un interrupteur positionné en amont de la ligne de transmission à une distance de la cavité correspondant à $(2n+1)\lambda_g/4$, avec n un nombre entier supérieur ou égal à zéro et $\lambda_g$ la longueur d'onde guidée par ladite ligne de transmission, ledit moyen de commutation étant adapté pour permettre de modifier le coefficient de couplage $\beta_i$ au niveau du port d'entrée de la cavité lors de la mesure du facteur de qualité à vide de ladite cavité d'au moins un facteur $10^3$.

Le dispositif selon l'invention permet de remplir très rapidement la cavité résonante de manière à minimiser l'apparition des décharges électroniques résonantes dans la cavité en minimisant la période durant laquelle les conditions d'apparition de décharge électronique résonante sont réunies. Pour cela, le coefficient de couplage du port incident est choisi avantageusement très élevé ($\beta_i \gg 1$), et typiquement entre 100 et 1000.

En effet, le remplissage rapide de la cavité résonante permet de modifier rapidement l'énergie des électrons et par conséquent les conditions susceptibles de favoriser l'apparition et le maintien des décharges électroniques résonantes dans la cavité. Ainsi grâce au remplissage rapide de la cavité résonante, la période pendant laquelle le coefficient d'émission secondaire est supérieur à 1 est minimisée, et les conditions de très hautes énergies sont rapidement atteintes.

En revanche, la mesure du facteur de qualité est réalisée avec un coefficient de couplage du port incident faible ($1 \ll \beta_i$), et typiquement entre 0,1 et 0,01, de manière à ne pas dégrader la précision de la mesure du facteur de qualité à vide.

Le basculement du coefficient de couplage du port incident est réalisé grâce au moyen de commutation rapide placé en amont de la ligne de transmission et à une distance correspondant à un multiple impair du quart de la longueur d'onde guidée.

Ainsi, le dispositif selon l'invention permet de court-circuiter très rapidement (i.e. en un temps très court par rapport au temps d'amortissement) le port d'entrée en ramenant à travers la ligne de transmission une impédance très faible.. On rappelle que le temps d'amortissement correspond au temps nécessaire à l'énergie stockée dans le résonateur pour décroître de 63,2% une fois le générateur de puissance coupé ou isolé.

La commutation a pour avantage de modifier le coefficient de couplage $\beta_i$ entre la phase de remplissage et la phase d'amortissement d'au moins un facteur $10^3$.

Ainsi, à titre d'exemple, le coefficient de couplage $\beta_i$, d'une valeur typiquement comprise entre 100 et 1000 lors de la phase de remplissage de la cavité, passe à une valeur typiquement comprise entre 0,01 et 0,1 au cours de la phase d'amortissement de manière très rapide (inférieur à 10 microsecondes).

L'invention a également pour avantage de garantir une précision de mesure équivalente à celle susceptible d'être obtenue avec un couplage critique sur le port incident, i.e. avec un coefficient de couplage incident égal à 1.

Le dispositif selon l'invention peut également présenter une ou plusieurs des caractéristiques ci-dessous, considérées individuellement ou selon toutes les combinaisons techniquement possibles :

- le moyen de commutation présente un temps de commutation, modifiant le coefficient de couplage $\beta_i$ au niveau du port d'entrée (2) de la cavité, égal ou inférieur à 1/100 du temps d'amortissement ;
- le moyen de commutation présente un temps de commutation, modifiant le coefficient de couplage $\beta_i$ au niveau du port d'entrée de la cavité, égal ou inférieur à 10 microsecondes ;
- le moyen de commutation modifie le coefficient de couplage $\beta_i$ au niveau du port d'entrée de la cavité au moins d'un facteur $10^3$;
- le moyen de commutation est réalisé à partir d'une diode PIN ou d'au moins deux diodes PIN montées en série ;
- le coefficient de couplage $\beta_i$ de la ligne de transmission au niveau du port d'entrée de la cavité est supérieur à 100 lorsque le moyen de commutation est fermé ;
- le coefficient de couplage $\beta_i$ de la ligne de transmission au niveau du port d'entrée de la cavité est inférieur à 0,1 lorsque le moyen de commutation est ouvert.

L'invention a également pour objet un système pour mesurer le facteur de qualité à vide d'une cavité résonante caractérisé en ce qu'il comporte :

- un générateur de puissance générant une puissance incidente apte à remplir d'énergie ladite cavité résonante ;
- un dispositif de mesure selon l'invention ;
- une cavité résonante à caractériser comportant un port d'entrée pour recevoir la puissance incidente et un port de sortie pour prélever et mesurer une partie de l'énergie stockée dans la cavité.

L'invention a également pour objet une méthode de mesure du facteur de qualité à vide d'une cavité résonante au moyen du système de mesure selon la revendication précédente caractérisée en ce qu'elle comporte :

- une étape de stockage de l'énergie fournie par le générateur dans ladite cavité ;

- une étape de commutation du moyen de commutation passant d'un état fermé à un état ouvert lorsque l'état stationnaire de la cavité est atteint et modifiant le coefficient de couplage $\beta_i$ au niveau du port d'entrée de la cavité ;

- une étape de prélèvement et de mesure d'une partie de l'énergie stockée dans la cavité résonante ;

- une étape de détermination du facteur de qualité à vide de ladite cavité résonante.

## BREVES DESCRIPTIONS DES FIGURES

D'autres caractéristiques et avantages de l'invention ressortiront plus clairement de la description qui en est donnée ci-dessous, à titre indicatif et nullement limitatif, en référence aux figures annexées, parmi lesquelles :

- la figure 1 est un schéma de principe d'un système de mesure du facteur de qualité à vide d'une cavité résonante selon l'invention ;
- la figure 2 illustre un schéma électrique du dispositif de commutation du système de mesure selon l'invention ;
- la figure 3 est une vue en perspective d'un exemple de cavité résonante pouvant être caractérisé par le système selon l'invention.

## DESCRIPTION D'AU MOINS UN MODE DE REALISATION

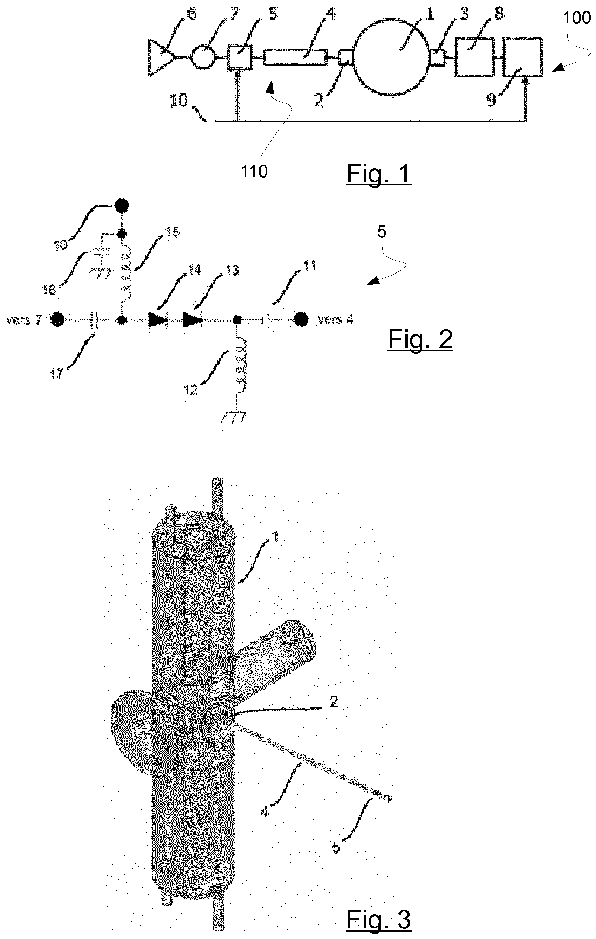

La figure 1 est un schéma représentant le système 100 de caractérisation du facteur de qualité à vide $Q_0$ d'une cavité résonante 1 de type supraconductrice.
Le système 100 comporte notamment :

- une cavité résonante 1 présentant un port d'entrée 2 (port incident) et un port de sortie 3 (port transmis) ;

- un générateur de puissance 6 permettant de remplir la cavité résonante 1 ;

- un dispositif 110 selon l'invention comportant: un interrupteur rapide 5 piloté par un signal de contrôle ; et une ligne de transmission 4 dit quart d'onde séparant l'interrupteur 5 de la cavité résonante 1.

La ligne de transmission 4 présente avantageusement une longueur L correspondant à un multiple impair de la longueur d'onde guidée dans la ligne de transmission 4, soit :

$$L = (2n+1)\,\lambda_g/4$$

Où n est un nombre entier supérieur ou égal à 0 et $\lambda_g$ la longueur d'onde guidée dans la ligne de transmission 4.
Le choix de la ligne de transmission, dite quart d'onde, doit répondre à un critère de perte minimale. Cette ligne de transmission est avantageusement réalisée par un câble coaxial présentant des pertes inférieures à 0,1 dB/m. Le nombre n entier de la longueur de la ligne de transmission sera choisi de préférence à zéro chaque fois que l'encombrement et la configuration de mesure le permettent.
Cette ligne de transmission 4 connecte le port d'entrée 2 de la cavité résonante 1 à l'interrupteur 5 monté en série comme illustré à la figure 1. L'interrupteur 5 est alimenté par un générateur de puissance 6 au travers d'un circulateur 7 positionné entre l'interrupteur 5 et le générateur de puissance 6.
L'interrupteur 5 est un interrupteur rapide permettant de passer d'un état fermé à un état ouvert rapidement (i.e. avec un temps de commutation égal ou inférieur à 1/10 du temps d'amortissement et avantageusement égal ou inférieur à 1/100 du temps d'amortissement) en modifiant le coefficient de couplage $\beta_i$ du port incident. Selon un mode de réalisation privilégié de l'invention, l'interrupteur 5 présente un temps de commutation égal ou inférieur à 10 $\mu$s.
Lorsque l'interrupteur 5 est fermé, le coefficient de couplage $\beta_i$ du port incident, typiquement de valeur entre 100 et 1000, n'est déterminé que par la géométrie du coupleur de la ligne de transmission au niveau du port d'entrée 2 de la cavité 1, i.e. la longueur de pénétration de l'antenne pour un couplage électrique ou bien la surface de la boucle pour un couplage inductif dans le cas d'une implémentation par une ligne coaxiale.
Lorsque l'interrupteur 5 est ouvert, ce dernier présente une impédance de fuite avantageusement élevée mise en série avec l'impédance source du générateur 6 (ou impédance de charge) que l'on nomme $Z_L$ pour représenter la somme des deux impédances. Ainsi, l'impédance vue au port incident correspond à :

$$Z_i = \frac{Z_0^2}{Z_L}$$

Avec $Z_0$ l'impédance caractéristique de la ligne de transmission, typiquement égale à 50 $\Omega$. Ainsi, à titre d'exemple, si la somme des deux impédances $Z_L$ vaut 500 k$\Omega$, alors l'impédance vue au niveau du port d'entrée serait de 5 m$\Omega$ lorsque l'interrupteur 5 est ouvert, ce qui revient quasiment à court-circuiter le port d'entrée.
Grâce à l'interrupteur rapide 5 du système selon l'invention permettant de réaliser une commutation entre deux états (fermé et ouvert) induisant une transformation d'impédance dans la ligne de transmission (i.e. en un état de court-circuit), le système selon l'invention permet d'obtenir un coefficient de couplage $\beta_i$ du port incident 2 très faible ($\beta_i \ll 1$) lors de la phase d'amortissement. Ainsi, en minimisant le coefficient de couplage du port incident ($\beta_i \ll 1$), on obtient grâce à la commutation rapide de l'interrupteur que le facteur de qualité en charge $Q_L$ est sensiblement équivalent au facteur de qualité à vide $Q_0$ de la cavité résonante 1 avec une erreur relative réduite à $2\Delta P/P$, $\Delta P/P$ représentant l'erreur relative sur les mesures de puissance.

Le facteur de qualité en charge $Q_L$ est mesuré à travers la décroissance dans le temps de la puissance transmise $P_t$ qui suit la loi suivante :

$$P_t = P_{t0}e^{-t/\tau}$$

où $\tau$ est le temps d'amortissement de la cavité, qui est égal par réciprocité au temps de remplissage de la cavité.

La mesure de la décroissance de l'énergie stockée dans la cavité 1 est réalisée par exemple par un détecteur à diode 8, sur le port transmis très faiblement couplé. La mesure permet de déterminer le temps d'amortissement puis le facteur de qualité à vide $Q_0$ de la cavité, par exemple au moyen d'un oscilloscope 9 déclenché par le signal impulsionnel de contrôle de l'interrupteur 5. Selon un autre mode de réalisation non représenté, le détecteur à diode 8 et l'oscilloscope 9 peuvent être remplacés par un analyseur de spectre configuré en mode balayage temporel.

La figure 2 illustre un exemple de réalisation de l'interrupteur rapide 5 du système 100 selon l'invention.

L'interrupteur rapide 5 est réalisé à partir d'au moins une diode PIN (pour Positive Intrinsic Negative en langue anglaise), connu sous le nom de SPST (pour Single Pole Single Through) ou de plusieurs diodes PIN montées en série pour obtenir les performances et les résultats souhaités. De façon générale, chacun des composants de l'interrupteur 5 est choisi de manière appropriée en fonction de la fréquence de résonance de la cavité 1, de la puissance crête et moyenne à transmettre à la cavité 1 ainsi que de l'ordre du facteur de qualité à vide $Q_0$ estimé.

L'interrupteur rapide 5 est piloté sur l'entrée 10 par un générateur d'impulsion générant le signal de contrôle de l'interrupteur 5. Les caractéristiques électriques du générateur d'impulsion doivent être compatibles avec les spécifications des diodes PIN choisies. A titre d'exemple, pour des diodes de type MA4P700, la tension positive appliquée est typiquement de 10 V et le courant fourni droit être d'au moins 100 mA pour la position fermée de l'interrupteur. La position fermée de l'interrupteur 5 permet donc d'avoir un coefficient de couplage $\beta_i$ fort pour la phase de remplissage de la cavité résonante 1. Pour passer de la position fermée à la position ouverte de l'interrupteur 5, le générateur d'impulsion applique une tension négative de -30 V sur l'entrée 10, ce qui permet d'avoir un coefficient de couplage $\beta_i$ plus faible lors de la phase d'amortissement qui correspond à la phase de mesure du facteur de qualité à vide.

Selon l'exemple de réalisation illustré à la figure 2, l'interrupteur 5 présente deux diodes 13 et 14 en série. Toutefois, l'interrupteur 5 peut comporter une diode montée en série par rapport au signal ou plusieurs diodes en série par rapport au signal. Le nombre de diodes en série est déterminé de manière à obtenir une variation du coefficient de couplage $\beta_i$ d'un facteur égal ou supérieur à $10^3$.

Les capacités 11 et 17 assurent le découplage du signal de pilotage 10 vis-à-vis de la cavité résonante 1 et du générateur de puissance 6. Réciproquement, les inductances 12 et 15 bloquent les courants hautes fréquences par rapport à la masse et au générateur d'impulsion générant le signal de contrôle de l'interrupteur 5. La capacité 16 sert à amortir les surtensions générées par les inductances lors de la commutation de l'interrupteur 6.

Ainsi à titre d'exemple, pour une cavité supraconductrice illustrée à la figure 3, utilisée pour l'accélération des noyaux de deutérium, et présentant une fréquence de résonance à 175 MHz, nécessitant une puissance incidente de 2 kW (crête et moyenne), présentant un facteur de qualité $Q_0$ estimé à $10^9$, et en représentant chaque diode PIN par son circuit équivalent en fonction de leur état : une résistance série de 0,8 $\Omega$ lorsqu'elle conduit (pendant la phase de remplissage) et une résistance en parallèle de 200 k$\Omega$ avec une capacité de 0,7 pF lorsqu'elle est bloquée (phase de mesure), le facteur de qualité du port d'entrée $Q_i$ avec un tel interrupteur 5 est de l'ordre de $10^6$ lors de la phase de remplissage et de l'ordre de $10^{10}$ lorsque les diodes sont bloquées lors de la phase de mesure, soit un rapport de l'ordre de $10^4$ entre les deux états de commutation de l'interrupteur.

Ainsi, le système selon l'invention permet d'éviter l'amorçage d'une décharge électronique résonante en minimisant le temps de remplissage de la cavité 1, de l'ordre de la milliseconde, afin que le champ dans la cavité 1 puisse croître suffisamment rapidement pour ne pas présenter des conditions stables à l'amorçage d'une décharge électronique résonante.

**Revendications**

1. Dispositif (110) pour mesurer le facteur de qualité à vide d'une cavité résonante (1) présentant un port d'entrée (2) pour recevoir une puissance incidente et un port de sortie (3) pour prélever et pour mesurer une partie de l'énergie stockée dans la cavité, ledit dispositif comportant une ligne de transmission (4) apte à être couplée au port d'entrée (2) de ladite cavité résonante (1) à caractériser, présentant un coefficient de couplage $\beta_i$ et apte à transmettre une puissance incidente;

ledit dispositif étant **caractérisé en ce qu'**il comporte un moyen de commutation (5) formé par un interrupteur positionné en amont de la ligne de transmission (4) à une distance de la cavité (1) correspondant à $(2n+1)\lambda_g/4$, avec n un nombre entier supérieur ou égal à zéro et $\lambda_g$ la longueur d'onde guidée par ladite ligne de transmission (4), ledit moyen de commutation (5) étant adapté pour permettre de modifier le coefficient de couplage $\beta_i$ au niveau du port d'entrée (2) de la cavité (1) lors de la mesure du facteur de qualité à vide de ladite cavité d'au moins un facteur 103.

2. Dispositif (110) pour mesurer le facteur de qualité à vide d'une cavité résonante (1) selon la revendication précédente **caractérisé en ce que** le moyen de commutation (5) présente un temps de commutation, modifiant le coefficient de couplage $\beta_i$ au niveau du port d'entrée (2) de la cavité (1), égal ou inférieur à 1/10 du temps d'amortissement.

3. Dispositif (110) pour mesurer le facteur de qualité à vide d'une cavité résonante (1) selon l'une des revendications précédentes **caractérisé en ce que** le moyen de commutation (5) présente un temps de commutation, modifiant le coefficient de couplage $\beta_i$ au niveau du port d'entrée (2) de la cavité (1), égal ou inférieur à 10 microsecondes.

4. Dispositif (110) pour mesurer le facteur de qualité à vide d'une cavité résonante (1) selon l'une des revendications précédentes **caractérisé en ce que** le moyen de commutation (5) est réalisé à partir d'une diode PIN montée en série ou d'au moins deux diodes PIN montées en série.

5. Dispositif (110) pour mesurer le facteur de qualité à vide d'une cavité résonante (1) selon l'une des revendications précédentes **caractérisé en ce que** le coefficient de couplage $\beta_i$ de la ligne de transmission au niveau du port d'entrée (2) de la cavité (1) est supérieur à 100 lorsque le moyen de commutation (5) est fermé.

6. Dispositif (110) pour mesurer le facteur de qualité à vide d'une cavité résonante (1) selon l'une des revendications précédentes **caractérisé en ce que** le coefficient de couplage $\beta_i$ de la ligne de transmission au niveau du port d'entrée (2) de la cavité (1) est inférieur à 0,1 lorsque le moyen de commutation est ouvert.

7. Système (100) pour mesurer le facteur de qualité à vide d'une cavité résonante (1) **caractérisé en ce qu'**il comporte :

    - un générateur de puissance (6) générant une puissance incidente apte à remplir d'énergie ladite cavité résonante (1) ;
    - un dispositif de mesure (110) selon l'un des revendications précédentes ;
    - une cavité résonante (1) à caractériser comportant un port d'entrée (2) pour recevoir la puissance incidente et un port de sortie (3) pour prélever et mesurer une partie de l'énergie stockée dans la cavité.

8. Méthode de mesure du facteur de qualité à vide d'une cavité résonante (1) au moyen du système de mesure selon la revendication précédente **caractérisée en ce qu'**elle comporte :

    - une étape de stockage de l'énergie fournie par le générateur (6) dans ladite cavité (1) ;
    - une étape de commutation du moyen de commutation (5) passant d'un état fermé à un état ouvert lorsque l'état stationnaire de la cavité (1) est atteint et modifiant le coefficient de couplage $\beta_i$ au niveau du port d'entrée (2) de la cavité (1)
    - une étape de prélèvement et de mesure d'une partie de l'énergie stockée dans la cavité résonante (1);
    - une étape de détermination du facteur de qualité à vide de ladite cavité résonante (1).

**Patentansprüche**

1. Vorrichtung (110) zur Messung des Vakuumqualitätsfaktors einer Resonanzausnehmung (1), die einen Eingangsport (2), um eine einfallende Leistung zu empfangen, und einen Ausgangsport (3), um einen Tel der in der Ausnehmung gelagerten Energie zu entnehmen und zu messen, aufweist, wobei die genannte Vorrichtung eine Übertragungslinie (4) umfasst, die geeignet ist, an den Eingangsport (2) der genannten, zu charakterisierenden Ausnehmung (1) gekoppelt zu sein, aufweisend einen Kopplungskoeffizienten βi und dazu geeignet, eine einfallende Leistung zu übertragen;
wobei die genannte Vorrichtung **dadurch gekennzeichnet ist, dass** sie ein Umschaltmittel (5) umfasst, das durch einen Schalter gebildet ist, der der Übertragungsleitung (4) in einer Entfernung der Ausnehmung (1) vorgeschaltet ist, die $(2n+1)\lambda_g/4$ entspricht, wobei n eine ganze Zahl ist, die größer als oder gleich Null ist, und $\lambda_g$ die von der genannten Übertragungslinie (4) geführte Wellenlänge ist, wobei das genannte Umschaltmittel (5) geeignet ist, um die Modifizierung des Kopplungskoeffizienten βi am Eingangsport (2) der Ausnehmung (1) bei der Messung des Vakuumqualitätsfaktors der genannten Ausnehmung mit einem Faktor von wenigstens $10^3$ zu ermöglichen.

2. Vorrichtung (110) zur Messung des Vakuumqualitätsfaktors einer Resonanzausnehmung (1) gemäß dem voranstehenden Anspruch, **dadurch gekennzeichnet, dass** das Kommunikationsmittel (5) eine Umschaltzeit aufweist, die den Kopplungskoeffizienten βi am Eingangsport (2) der Ausnehmung (1) abändert, von gleich oder kleiner als 1/10 der Amortisierungszeit.

3. Vorrichtung (110) zur Messung des Vakuumqualitätsfaktors einer Resonanzausnehmung (1) gemäß einem der voranstehenden Ansprüche, **dadurch gekennzeichnet, dass** das Umschaltmittel (5) eine Umschaltzeit aufweist, die den Kopplungskoeffizienten βi am Eingangsport (2) der Ausnehmung (1) abändert, von gleich oder kleiner als 10 Mikrosekunden.

4. Vorrichtung (110) zur Messung des Vakuumqualitätsfaktors einer Resonanzausnehmung (1) gemäß irgendeinem der voranstehenden Ansprüche, **dadurch gekennzeichnet, dass** das Umschaltmittel (5) ausgehend von einer in Serie geschalteten PIN-Diode oder von wenigstens zwei in Serie geschalteten PIN-Dioden realisiert ist.

5. Vorrichtung (110) zur Messung des Vakuumqualitätsfaktors einer Resonanzausnehmung (1) gemäß irgendeinem der voranstehenden Ansprüche, **dadurch gekennzeichnet, dass** der Kopplungskoeffizient βi der Übertragungslinie am Eingangsport (2) der Ausnehmung (1) größer als 100 ist, wenn das Kommunikationsmittel (5) geschlossen ist.

6. Vorrichtung (110) zur Messung des Vakuumqualitätsfaktors einer Resonanzausnehmung (1) gemäß einem der voranstehenden Ansprüche, **dadurch gekennzeichnet, dass** der Kopplungskoeffizient βi der Übertragungslinie am Eingangsport (2) der Ausnehmung (1) kleiner ist als 0,1, wenn das Umschaltmittel offen ist.

7. System (100) zur Messung des Vakuumqualitätsfaktors einer Resonanzausnehmung (1), **dadurch gekennzeichnet, dass** es umfasst:

   - einen Leistungsgenerator (6) der eine einfallende Leistung generiert, die geeignet ist, die genannte Resonanzausnehmung (1) zu füllen;
   - eine Messvorrichtung (110) gemäß einem der voranstehenden Ansprüche;
   - eine zu charakterisierende Resonanzausnehmung (1), umfassend einen Eingangsport (2) zur Aufnahme der einfallenden Leistung und einen Ausgangsport (3) zur Entnahme und Messung des Teils der in der Ausnehmung gespeicherten Energie.

8. Messverfahren des Vakuumqualitätsfaktors einer Resonanzausnehmung (1) mittels des Messsystems gemäß dem voranstehenden Anspruch, **dadurch gekennzeichnet, dass** sie umfasst:

   - einen Speicherschritt der von dem Generator (6) in der genannten Ausnehmung (1) gelieferten Energie;
   - einen Umschaltschritt des Umschaltmittels (5), der von einem geschlossenen Zustand in einen offenen Zustand übergeht, wenn der stationäre Zustand der Ausnehmung (1) erreicht ist und den Kopplungskoeffizienten βi am Eingangsport (2) der Ausnehmung (1) abändert
   - einen Entnahme- und Messschritt eines Teils der in der Resonanzausnehmung (1) gespeicherten Energie;
   - einen Bestimmungsschritt des Vakuumqualitätsfaktors der genannten Resonanzausnehmung (1).

**Claims**

1. Device (110) for measuring the unloaded quality factor of a resonant cavity (1) which has an input port (2) to receive incident power and an output port (3) for sampling and for measuring a portion of the energy stored in the cavity, said device comprising a transmission line (4) designed to be coupled to the input port (2) of said resonant cavity (1) to be characterised, exhibiting a coupling coefficient $\beta_i$ and designed to transmit incident power;
   wherein said device comprises a switching means (5) formed by a switch placed upstream of the transmission line (4) at a distance from the cavity (1) equivalent to $(2n+1)\lambda_g/4$, where n is a whole number greater than or equal to zero and $\lambda_g$ the wavelength of the wave guided by said transmission line (4), said means of switching (5) allowing the coupling coefficient $\beta_i$ at the input port (2) of the cavity (1) to be changed during measurement of the unloaded quality factor of said cavity (1) by at least a factor of $10^3$.

2. Device (110) for measuring the unloaded quality factor of a resonant cavity (1) according to the preceding claim, wherein the means of switching (5) have a switching time for modifying the coupling coefficient $\beta_i$ at the input port (2) of the cavity (1) which is equal to or less than 1/10 of the damping time.

3. Device (110) for measuring the unloaded quality factor of a resonant cavity (1) according to any of the preceding claims, wherein the means of switching (5) has a switching time for modifying the coupling coefficient $\beta_i$ at the input port (2) of the cavity (1) which is equal to or less than 10 microseconds.

4. Device (110) for measuring the unloaded quality factor of a resonant cavity (1) according to any of the preceding claims, wherein the means of switching (5) is made from a PIN diode placed in series or from at least two PIN diodes placed in series.

5. Device (110) for measuring the unloaded quality factor of a resonant cavity (1) according to any of the preceding claims, wherein the coupling coefficient $\beta_i$ of the transmission line at the input port (2) of the cavity (1) is greater than 100 when the means of switching (5) are closed.

6. Device (110) for measuring the unloaded quality factor of a resonant cavity (1) according to any of the preceding claims, wherein the coupling coefficient $\beta_i$ of the transmission line at the input port (2) of the cavity (1) is less than 0.1 when the means of switching are open.

7. System (100) for measuring the unloaded quality factor of a resonant cavity (1), wherein said system comprises:

> - a power generator (6) which generates an incident power which is designed to fill said resonant cavity (1) with energy;
> - a measuring device (110) according to one of the previous claims;
> - a resonant cavity (1) to be characterised which comprises an input port (2) to receive the incident power and an output port (3) to sample and measure a portion of the energy stored in the cavity.

8. Method for measuring the unloaded quality factor of a resonant cavity (1) using the measurement system according to the preceding claim, wherein said method comprises:

> - a step for storage of the energy provided by the generator (6) in said cavity (1);
> - a step for switching of the means of switching (5) changing from a closed state to an open state when the steady state of the cavity (1) is achieved and which modifies the coupling coefficient $\beta_i$ at the input port (2) to the cavity (1);
> - a step for sampling and for measurement of a portion of the energy stored in the resonant cavity (1);
> - a step for determination of the unloaded quality factor of said resonant cavity (1).

Fig. 1

Fig. 2

Fig. 3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

*   FR 27118247 A1

**Littérature non-brevet citée dans la description**

*   **J.M.R. VAUGHAN.** Multipactor. *IEEE transaction on electron devices,* 1988, vol. 35 (7

*   **JENS KNOBLOCH.** *Basic Concepts of Measurements Made on Superconducting RF Cavities,* 30 Août 1991